Europäisches Patentamt

European Patent Office

Office européen des brevets

(11) Veröffentlichungsnummer: **0 038 496**
A1

(19)

## (12) EUROPÄISCHE PATENTANMELDUNG

(21) Anmeldenummer: 81102767.1

(22) Anmeldetag: 10.04.81

(51) Int. Cl.³: **H 02 M 1/08**
H 03 K 5/00, H 03 H 9/15

(30) Priorität: 21.04.80 DE 3015301
19.09.80 DE 3035503
28.10.80 DE 3040530
30.10.80 DE 3040916

(43) Veröffentlichungstag der Anmeldung:
28.10.81 Patentblatt 81/43

(84) Benannte Vertragsstaaten:
AT BE CH DE FR GB IT LI NL SE

(71) Anmelder: SIEMENS AKTIENGESELLSCHAFT Berlin
und München
Postfach 22 02 61
D-8000 München 22(DE)

(72) Erfinder: Mágori, Valentin, Dipl.-Phys.
Limburgstrasse 17
D-8000 München 90(DE)

(72) Erfinder: Kleinschmidt, Peter, Dipl.-Phys.
Klagenfurter Strasse 12
D-8000 München 90(DE)

(54) Zündeinrichtung und Piezo-Zündkoppler mit galvanischer Entkopplung.

(57) Piezo-Zündeinrichtung für elektronische Schalter (10) mit galvanischer Entkopplung von Eingangssteuerelektronik (9) und elektronischem Schalter (10) mit einem Plättchen aus piezokeramischem Material mit Elektrodenpaaren (13, 13', 14, 14') als ein Eingangselektrodenpaar (13,13') und wenigstens ein Ausgangselektrodenpaar (14,14') und gegebenenfalls mit Rückkopplungselektrode. Von der Eingangssteuerelektronik (9) erhält das Eingangselektrodenpaar (13,13') des Plättchens einen Ansteuer-Zündimpuls, der insbesondere eine getaktete Wechselspannung ist. Die Frequenz dieser Wechselspannung und die Resonanzfrequenz eines bevorzugten Schwingungsmodes des Plättchens mit mehr als zweizähliger Drehsymmetrie sind aufeinander abgestimmt bemessen. Die wirksamen Flächen von Eingangselektrodenpaar (13,13') und Ausgangselektrodenpaar (14, 14') sind im wesentlichen gleich groß bemessen, so daß vorzugsweise eine 1:1 Signalübersetzung vom Eingangselektrodenpaar (13,13') zum Ausgangselektrodenpaar (14,14') besteht. Eine vorzugsweise vorgesehene Rückkopplungselektrode ist bevorzugt im Bereich einer Schwingungsknotenlinie der mechanischen Spannung des nächsthöheren Radialschwingungsmodes vorgesehen.

FIG 1

0038496

SIEMENS AKTIENGESELLSCHAFT
Berlin und München

Unser Zeichen
VPA 80 P 7046

Zündeinrichtung und Piezo-Zündkoppler mit galvanischer Entkopplung.

Die Erfindung bezieht sich auf eine Zündeinrichtung und einen Piezo-Zündkoppler, für elektronische Schalter wie Thyristoren, Triacs und MOS-Leistungsschalter, wie im Oberbegriff des Patentanspruchs 1 angegeben ist.

Für das Zünden von Thyristoren mit Hilfe einer vom Thyristor galvanisch entkoppelten Steuerelektronik ist es bekannt, zwischen dem jeweiligen Thyristor und der Steuerelektronik einen Übertrager mit zwei galvanisch nicht miteinander verbundenen Wicklungen zu verwenden. Für denselben Zweck kann auch ein optoelektronisches Koppelelement verwendet werden.

Bei der Verwendung eines wie angegebenen Übertragers ist es notwendig, derjenigen (Sekundär-)Wicklung des Übertragers, die mit der Zündelektrode des Thyristors verbunden ist, einen Kondensator parallel zu schalten, damit von der Ausgangsseite bzw. der Lastseite des Thyristors her eingespeiste Störsignale den Thyristor über die Gitter-Anoden-Kapazität desselben nicht zur Zündung kommen lassen.

Ein solcher Kondensator ist ein zusätzlicher Aufwand. Für den Fall der Verwendung eines optoelektronischen Koppelelementes ist auf der Sekundärseite noch eine Hilfs-Spannungsversorgung vorzusehen, die noch größeren zusätzlichen Aufwand bedeutet.

Bts 1 Bla / 5.3.1981

Aus "Siemens Components" 18 (1980), Heft 4, Seiten 187/188 ist eine Schaltung für eine galvanisch getrennte Ansteuerung eines SIPMOS-Leistungsschalters bekannt, wobei als Vorrichtung zur galvanisch getrennten Übertragung des Ansteuersignals ein Übertrager mit drei Wicklungen vorgesehen ist. Bild 1 dieser Druckschrift zeigt ein Schaltungsbeispiel für eine derartige Ansteuerung mit Übertrager. Der SIPMOS-Leistungsschalter ist ein Halbleiterbauelement und diese Bezeichnung hat die Bedeutung "Siemens-Power-MOS-Leistungsschalter". Wie auch das Bild 1 der Druckschrift erkennen läßt, ist dieser Leistungsschalter im wesentlichen ein Feldeffekttransistor, der einen derartigen (konstruktiven) Aufbau in dem Halbleiter-Chip hat und der nach der bekannten MOS-Technologie hergestellt ist, so daß mit diesem Halbleiterbauelement große Ströme geschaltet werden können. Solche Leistungsschalter können z.B. zum Schalten des Betriebsstromes eines Motors verwendet werden.

Einzelheiten über MOS-Leistungsschalter gehen auch aus "Siemens Forschungs- und Entwicklungsberichte", Bd.9, (1980), Nr.4, Seiten 181-189 hervor.

Galvanisch getrennte Ansteuerung derartiger MOS-Leistungsschalter ist überall dort erwünscht, wo Berührungsschutz mit hohen Spannungen erforderlich ist. Ein MOS-Leistungsschalter läßt sich bereits mit 6 Volt zuverlässig ein- und ausschalten, obwohl die von dem Leistungsschalter zu schaltende Spannung ohne weiteres mehrere hundert Volt betragen kann und insbesondere die Netzspannung ist.

Für die galvanisch getrennte Ansteuerung eines MOS-Leistungsschalters kann prinzipiell auch ein Kleinrelais oder ein optoelektronischer Koppler (auf optischem

-3-

Wege koppelndes Element aus eingangsseitiger Fotodiode und ausgangsseitigem Fototransistor) verwendet werden, was jedoch zu zusätzlichen Aufwendungen, wie z.B. Zusatzschaltungen, insbesondere für Strombegrenzung und/ oder zum Erfordernis einer zusätzlichen Spannungsquelle auf der Lastseite führt.

Für die Ansteuerung bzw. für das Zünden eines Thyristors und/oder eines Triacs wird eine elektrische Leistung von ca. 10 mW bei ca. 2 Volt Spannung benötigt.

Es ist eine Aufgabe der vorliegenden Erfindung, eine solche Zündeinrichtung mit galvanischer Entkopplung anzugeben, die mit einem minimalen technischen Aufwand realisierbar ist und die insbesondere keine Zusätze, z.B. wie oben beschrieben, benötigt. Insbesondere soll diese neue Zündeinrichtung mit möglichst niedriger Versorgungsspannung, z.B. $\leq 5$ Volt, auf der Eingangs- bzw. Primärseite betrieben werden können, um an Mikroprozessor-Systeme angepaßt zu sein.

Es ist eine Detail-Aufgabe der vorliegenden Erfindung, eine andere galvanisch getrennte Ansteuerungsmöglichkeit eines MOS-Leistungsschalters anzugeben, die nicht nur die Vorteile des Prinzips nach der obengenannten Druckschrift hat, sondern die außerdem auch noch mit weniger aufwendigen Mitteln zu realisieren ist.

Es ist eine Detail-Aufgabe der vorliegenden Erfindung, Maßnahmen anzugeben, mit deren Hilfe eine stets ausreichende Übereinstimmung von Anregungsfrequenz der Ansteuereinrichtung und Eigenresonanzfrequenz des Piezo-Kopplers, und zwar ohne größeren Aufwand zu treiben, gewährleistet ist.

Diese Aufgabe wird mit einer Zündeinrichtung nach dem Oberbegriff des Patentanspruchs 1 erfindungsgemäß mit den Merkmalen des Kennzeichens des Patentanspruchs 1 gelöst. Für diese Zündeinrichtung bevorzugte und an deren Betriebsweise angepaßte Ausgestaltungen des Piezo-Zündkopplers und Weiterbildungen der Erfindung gehen aus den Unteransprüchen hervor.

Die Erfindung geht von der Überlegung aus, daß die erforderliche Zündleistung auf der Ausgangsseite eines solchen Plättchens aus Piezokeramik entnommen werden kann, und zwar mit einer elektrischen Spannung von einigen Volt, wie dies für das Zünden z.B. eines Thyristors erforderlich ist. Bei der Erfindung wird die Eingangsseite des Plättchens durch Drucksignale angeregt, die piezoelektrisch durch ein angelegtes elektrisches Signal erzeugt werden. Für dieses elektrische Anregungssignal wird eine nur etwa um das 4-fache größere Eingangsleistung benötigt, da eine wie erfindungsgemäße Zündeinrichtung mit Plättchen aus piezokeramischem Material einen Wirkungsgrad von wenigstens 25% zwischen Eingang und Ausgang hat. Die auf der Eingangsseite angeschlossene Steuerelektronik, z.B. ein Mikroprozessor, liefert diese elektrische Leistung bei einer Betriebsspannung von ebenfalls nur wenigen Volt. Eingangs- und ausgangsseitig treten in der Größenordnung etwa gleich große Spannungswerte auf.

Ein Piezo-Zündkoppler in der Zündeinrichtung kann mit einem Impulssignal, insbesondere Rechteckimpulssignal, und auch mit einem Wechselspannungssignal gespeist werden. Es ist auch möglich, dadurch zu zünden, daß man den erfindungsgemäßen Piezo-Zündkoppler mit einer elektrischen Spannung langsam auflädt und nachfolgend einen Kurzschluß der Eingangsseite, nämlich eine fast schlagartige Änderung des Aufladungszustandes der Eingangsseite, vornimmt. Dies wirkt als Eingangssignal für die
Erzeugung eines Ausgangs-Zündsignals.

Von besonderem Vorteil ist es, in der erfindungsgemäßen
Zündeinrichtung den Piezo-Zündkoppler mit entsprechend
der vorgesehenen Steuerung getaktetem Wechselspannungsimpuls einer solchen Wechselspannungsfrequenz anzuregen,
die in Resonanz mit einer Eigenschwingung des Körpers
des Kopplers ist.

Ein solcher, vorangehend vorzugsweise für Thyristoren
und Triacs beschriebener Piezo-Koppler läßt sich auch
für die Ansteuerung von MOS-Leistungsschaltern verwenden.
Das in das Eingangselektrodenpaar eingegebene primärseitige Ansteuersignal wird auf piezoelektrischem Wege
in den Bereich des wenigstens einen Ausgangselektrodenpaares übertragen, und an den Ausgängen dieses Elektrodenpaares tritt das dem Gate-Anschluß des MOS-Leistungsschalters zuzuführende, diesen Schalter steuernde Signal
auf. Der bei der Erfindung vorgesehene Piezo-Koppler
ersetzt die aufwendigen Trenntransformatoren der Schaltung nach der obengenannten Druckschrift "Siemens Components". Da der Piezo-Koppler der vorliegenden Erfindung auf der Sekundärseite in sich als Spannungsgenerator wirksam wird, kann mit diesem Koppler eine elektrische
Spannung bzw. eine elektrische Leistung erzeugt werden,
die nicht nur vom Eingang galvanisch getrennt ist, sondern die auch gegen ein Bezugspotential der Sekundärseite bzw. gegen Masse frei ist. Steht z.B. eine Betriebsspannung von 12 Volt mit an Masse liegendem Minuspol zur Verfügung (Autoelektrik), so kann mit dem erfindungsgemäßen Piezo-Koppler ohne weiteres eine solche
Gate-Spannung erzeugt werden, deren Minus-Potential
auf wenigstens angenähert 12 Volt liegt und deren Plus-

Potential beispielsweise bis zu +18 Volt gegenüber dem Minus-Potential der Betriebsspannung beträgt. Damit kann nämlich der MOS-Leistungsschalter in bezug auf den Lastwiderstand auch so eingefügt werden, daß der Drain-Anschluß des Leistungsschalters direkt mit dem Pluspol der Betriebsspannung verbunden ist und dessen Source-Anschluß mit dem einen Anschluß des Lastwiderstands verbunden ist, wobei dessen anderer Anschluß mit dem auf Masse liegenden Minuspol verbunden ist. Es kann also, wie in der Autoelektrik üblich, der eine Pol des Lastwiderstands (z.B. Scheinwerferbirne, Scheibenwischermotor, Gebläsemotor, u.s.w.) wie bisher mit der auf dem Minuspol liegenden Fahrzeugkarosserie direkt verbunden werden und dennoch ein verfügbarer Halbleiter-MOS-Leistungsschalter verwendet werden (der einen N-Kanal-Auf-bau hat; Feldeffekttransistor vom Anreicherungstyp).

Bei denjenigen Ausführungsformen des erfindungsgemäßen Piezo-Zündkopplers, die für primärseitiges Wechselspannungssignal in Resonanz ausgebildet sind, sind die Merkmale dieser Ausführungsformen insgesamt derart aufeinander abgestimmt, daß bei im wesentlichen minimaler Größe des Körpers des Kopplers dennoch eine derart große piezoelektrische Kopplung vom Eingang zum Ausgang vorliegt, daß das vom piezoelektrischen Körper des Kopplers an dessen Ausgang auftretende elektrische Zündsignal stets ausreichend ist, den Thyristor oder den Triac der jeweils vorgesehenen Type sicher, zuverlässig und rasch zu zünden. Dazu trägt zum einen die vorgesehene Mindest-größe der Dielektrizitätskonstante $\varepsilon$ bei. Infolge der wie vorgesehen geringen Plattendicke d liegt eine solche Kapazität der Eingangs-Elektrodenpaare vor, daß ein genügend großer Zündstrom I auftritt.

Die bei einer Ausführungsform für Resonanz-Wechselspannung im Piezo-Zündkoppler im Betrieb auftretende, durch Wechselspannungsanregung U erzeugte mechanische Resonanzschwingung der Frequenz f führt entsprechend der mechanischen Güte Q des piezokeramischen Materials des Körpers zu hohem Zündstrom I. Die Wahl des Körpers in Form einer Platte mit einer solchen, eine mehr als zweizählige (insbesondere vier- und mehrzählige) Drehachse aufweisende symmetrischen Form, die durch nur eine Längsabmessung bereits vollständig bestimmt ist (z.B. quadratische Form, Form eines regelmäßigen Fünfecks, Sechsecks oder Vielecks bis zur Kreisplatte), führt zu besonders starker Resonanzschwingung mit mehr als zweizähliger Drehsymmetrie der Schwingungsform (vor allem bei einer Kreisscheibe als Radialschwingung bezeichnet) auf einer von dieser Abmessung bestimmten Resonanzfrequenz. Der frequenzmäßig nächstbenachbarte unerwünschte Schwingungsmode liegt bei einem solchen Körper so weit von der Resonanzfrequenz des gewünschten (Radial-)Schwingungsmode entfernt, daß mit der Eingangs-Wechselspannung U der Steuerelektronik nur dieser eine gewünschte Schwingungsmode - dafür aber mit voller Intensität - angeregt wird. Eine Anregungsfrequenz bzw. Resonanzfrequenz zwischen 20 kHz und 500 kHz ist so hoch bemessen, daß die Anzahl der mechanischen Schwingungen pro Zeiteinheit so groß ist, daß es für die Präzision des Zündzeitpunkts des Thyristors oder Triacs unwesentlich ist, bei der wievielten Schwingung die Zündung desselben tatsächlich eintritt.

Der Zündstrom I entspricht der Gleichung

$$I = U \cdot 2\pi f \cdot C \cdot Q \cdot k^2 .$$

Die in der Gleichung enthaltenen Symbole entsprechen den obigen Erläuterungen und k ist der Kopplungsfaktor

-8-

des piezokeramischen Materials des Zündkopplers.

Eine besonders kräftige Kopplung wird im allgemeinen bei Resonanzanregung im Grundschwingungsmode erreicht. Für eine ausreichend große Kapazität C ist jedoch bei vorgegebener - möglichst geringer - Dicke d des plattenförmigen Körpers eine Mindestfläche der Platte erforderlich. Sollte diese errechnete Mindestfläche im Einzelfall so groß sein, daß die entsprechende, die Plattengröße bestimmende Längenabmessung wiederum so groß wird, daß die Grundresonanzfrequenz unter die untere Grenze von 20 kHz fallen sollte, wird die Anregung in einer zu diesem Schwingungstyp gehörenden n-ten, vorzugsweise ersten, Oberwelle vorgesehen, die um ein Vielfaches höhere Frequenz als die zugehörige Grundschwingung hat. Entsprechend dem Schwingungsmode - Grundschwingung oder Oberwellenschwingung - sind die Elektroden der Elektrodenpaare so anzuordnen, daß sie im wesentlichen diejenigen Flächenanteile der Plattenoberfläche bedecken, in denen für den gewählten Schwingungsmode große bis maximale Schwingungsamplitude, d.h. sogenannter Schwingungsbauch, auftritt.

Eine weitere Ausgestaltung der Erfindung beruht auf der Überlegung, daß durch Ausnutzung des Rückkopplungseffekts eine Vereinfachung der Eingangselektronik erreichbar ist.

Mit der Wechselspannungs-Ansteuerung nach dem Vorangehenden ist nämlich dann ein Nachteil verbunden, wenn (z.B. aus Preisgründen) nur geringere Toleranzforderungen für Frequenzgenauigkeit und Frequenzkonstanz des Piezo-Kopplers erfüllt werden können. Für eine weitreichende und mengenmäßig große Anwendung derartiger Piezo-Koppler müssen diese preisgünstig sein, was Zugeständnisse bezüglich Frequenzkonstanz und Frequenzgenauigkeit erfordert.

Die damit verbundenen Probleme lassen sich aber mit dem Prinzip lösen, zusätzlich selbsterregten Schwingbetrieb des Piezo-Kopplers vorzusehen. Es ist dazu zusätzlich eine weitere speziell dimensionierte, geformte und an ausgewähltem Ort der Oberfläche des Plättchens angebrachte Elektrode als Rückkopplungselektrode vorgesehen. Wichtig ist es nämlich, und zwar mit einfachsten Mitteln, zu verhindern, daß ein falscher Schwingungsmode des Piezo-Kopplers angeregt wird oder gar während des Betriebs ein Wechsel des Schwingungsmode eintritt. Die weitere Elektrode ist z.B. streifenförmig und im Bereich einer Knotenlinie einer möglichen störenden Oberschwingung angeordnet. Für diese soweit beschriebenen zusätzlichen Maßnahmen genügt dann aber, daß die Eingangselektronik lediglich noch einen oder mehrere C-MOS-Inverter und zusätzlich einen in seinem Wert unkritischen Festwiderstand hat. An einem Eingang des Inverters läßt sich dessen Verstärkung derart steuern, daß in einem Zustand minimaler Verstärkung keine Erzeugung einer Resonanzschwingung im Piezo-Koppler auftritt und im anderen Zustand eine wie angegebene Verstärkung vorliegt, die zuverlässiges Anschwingen und Weiterschwingen in der geforderten Resonanz gewährleistet.

Weitere Erläuterungen der Erfindung gehen aus den nachfolgenden Beschreibungen von bevorzugten Ausführungsbeispielen der Erfindung hervor, zu denen die Figuren gehören.

Fig.1 zeigt eine Zündeinrichtung mit Piezo-Zündkoppler.
Fig.2 zeigt eine Ausführungsform eines Piezo-Zündkopplers in verschiedenen Formenvarianten.
Fig.3 zeigt eine Erläuterung zum Oberwellen-Schwingungsmode.

Fig.4 zeigen weitere Ausführungsformen eines Piezo-
Fig.5 Zündkopplers.
Fig.6

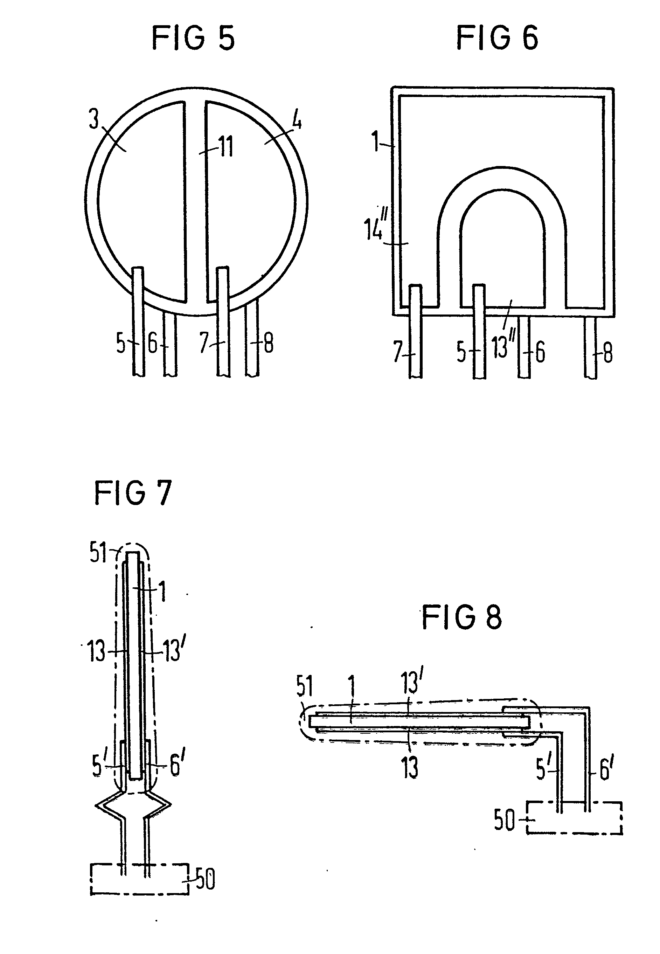

Fig.7 zeigen Ausgestaltungen bezüglich der halternden
Fig.8 Anschluß=Zuleitungen.

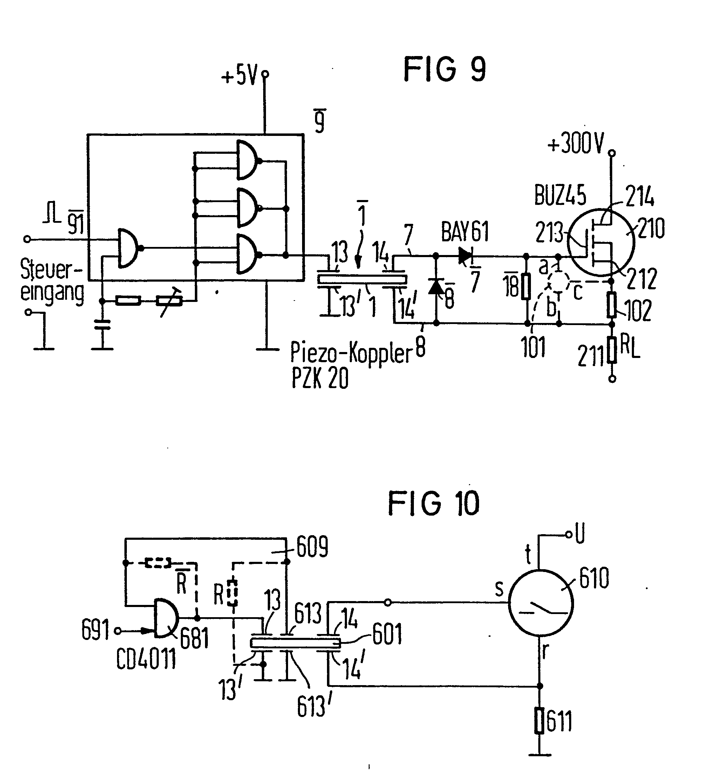

Fig.9 zeigt ein Schaltbild für die Anwendung für einen
MOS-Schalter.

Fig.10 zeigt ein Prinzipschaltbild mit Rückkopplung.

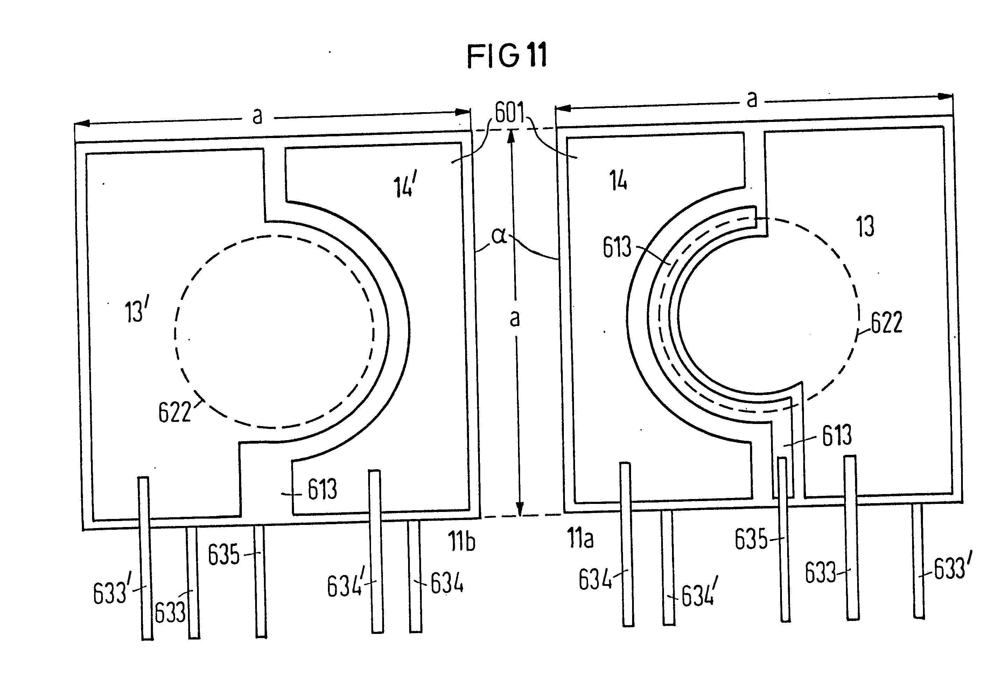

Fig.11 zeigen prinzipielle Formen des Plättchens des
a und b Piezo-Kopplers mit Rückkopplung.

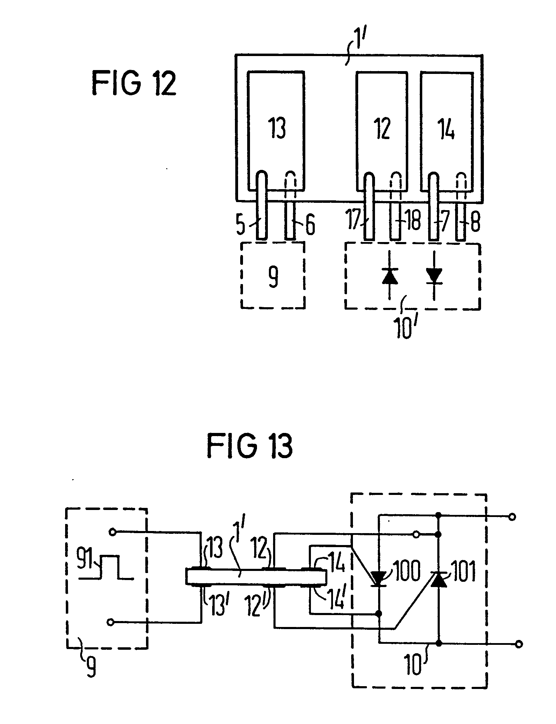

Fig.12 zeigen eine besondere Ausführungsform eines Piezo-
und 13 Kopplers und eine zugehörige Schaltung, und zwar
für eine solche mit Ausgangselektroden.

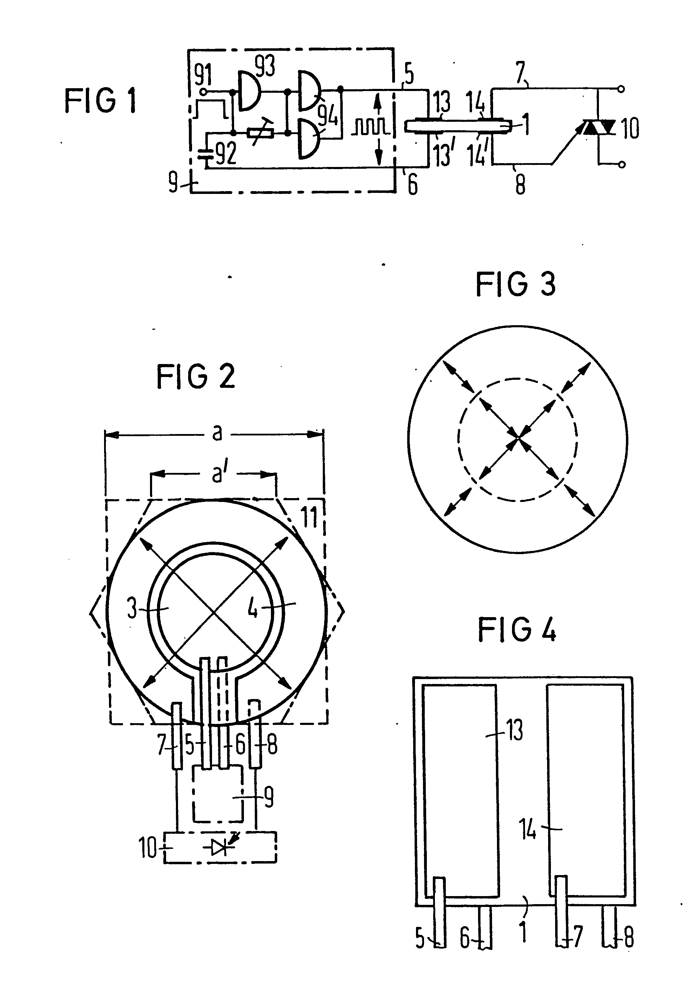

Fig.1 zeigt das Prinzipschaltbild einer erfindungsgemäßen Zündeinrichtung mit Piezo-Zündkoppler. Mit 1 ist der plättchenförmige Körper des Piezo-Zündkopplers bezeichnet. Auf der in der Figur oberen (senkrecht zur Darstellungsebene der Figur liegenden) Oberflächenseite des Körpers 1 befinden sich die streifenförmigen Elektroden 13 und 14. Diese Elektroden 13 und 14 haben einen so großen Abstand voneinander, daß den VDE-Bestimmungen (und den nationalen bzw. internationalen Bestimmungen anderer Länder) genügender Isolationswiderstand, d.h. genügende galvanische Entkopplung, vorliegt. Auf der Unterseite des Körpers befinden sich die ebenfalls streifenförmigen Elektroden 13' und 14'. Auch sie haben den vorgeschriebenen Isolationsabstand voneinander, sofern zweipolige galvanische Trennung von Eingang und Ausgang voneinander gefordert ist. Die Elektroden 13 und 13' bilden das eingangsseitige Elektrodenpaar und die Elektroden 14 und 14' das ausgangsseitige Elektrodenpaar des Piezo-Zündkopplers. Die jeweils einander gegenüberliegenden Elektroden 13, 13' bzw. 14, 14' dieser einzelnen Elektrodenpaare sind einander deckend angeordnet. Die Elektrodenpaare 13, 13' und 14, 14' bilden zwei Kapazitäten. Eine an die den Elektroden 13, 13' der Eingangsseite angelegte elektrische Impulsspannung, z.B. eine Rechteckimpulsspannung, wie mit 91 angedeutet, oder ein Einschaltstoß, erzeugt im Körper 1 eine mechanische bzw. akustische Welle, und zwischen den Elektroden 14, 14' auf der Ausgangsseite kann dann eine elektrische Spannung (umgekehrter Piezoeffekt) abgenommen werden.

Für eingangsseitig angelegte (getaktete) Wechselspannung, die in Resonanz mit dem Körper 1 abgestimmt ist, ergibt sich im Körper 1 eine mechanische Resonanzschwingung. Die örtliche Verteilung der Größe des piezoelektrischen Effekts bzw. des umgekehrten piezoelektrischen Effekts hängt bei Resonanzschwingung des Körpers 1 von der schwingungsmäßigen mechanischen Spannungsverteilung ab, die bei bevorzugt vorgesehener Radialschwingung für die Grundschwingung ein Maximum in der Plattenmitte (Schwingungsbauch) und z.B. für die ebenfalls in Frage kommende erste Oberwelle wiederum ein Maximum in der Plattenmitte und dazu ein symmetrisches (bei Kreisplatte ringförmig konzentrisch) verteiltes weiteres Maximum mit zwischen beiden Maxima vorhandener Knotenlinie hat. Dies gilt für die freischwingende Platte, wie sie bei der Erfindung vorgesehen ist, denn die noch zu erläuternden Halterungen sind so angebracht und ausgebildet, daß sie freie Resonanzschwingung der Platte des Körpers 1 zulassen.

Mit 9 ist eine Treiberschaltung für den speziellen Resonanzbetrieb bezeichnet, die bei Anliegen von H-Potential am Steuereingang 91 der vorgesehenen Steuerung des Thyristors entsprechend getaktetes Signal an das Elektrodenpaar 13, 13' liefert. Dieses Signal ist ein Wechselspannungssignal mit wie vorgegebener, durch die Abmessung des Körpers 1 bestimmter Frequenz zwischen 20 kHz und 500 kHz. Die Frequenz f der Wechselspannung und die zur Anregung vorgesehene Schwingungsresonanz des Körpers 1 sind somit übereinstimmend.

Die eine Elektrode 14 des ausgangsseitigen Elektrodenpaares ist mit der einen Elektrode des zu zündenden Thyristors oder Triacs 10 verbunden. Die andere Elektrode 14' ist mit der Zündelektrode dieses Thyristors oder Triacs in Verbindung. Zwischen Kathode und Anode liegt die Betriebsspannung an.

In Fig.2 ist ein erstes Ausführungsbeispiel dargestellt. Mit 11 ist eine Scheibe mit z.B. 20 mm Durchmesser $\phi$ und z.B. 0,1 bis 0,2 mm Dicke aus piezoelektrischer Keramik bezeichnet. Bei der piezoelektrischen Keramik handelt es sich z.B. um ein als Bleizirkonat-Titanat bekanntes Material, das wie das noch bekanntere, ebenfalls in Frage kommende Bariumtitanat durch Sinterung zu einem Keramikkörper hergestellt wird. Dieses Plättchen 11 bzw. diese Folie hat auf ihren beiden Oberflächen, von denen in der Darstellung der Fig.2 nur die eine Oberfläche zu sehen ist, je eine Elektrode. Diese Elektroden sind eine kreisrunde Elektrode 3 und eine ringförmige Elektrode 4, die konzentrisch zueinander sind. Zu der Elektrode 3 gehört eine praktisch gleich große, auf der gegenüberliegenden Oberfläche des Plättchens 11 befindliche Gegenelektrode, die beide zusammen ein Elektrodenpaar, z.B. das Eingangselektrodenpaar, bilden. Der Elektrode 4 liegt eine entsprechende ringförmige Gegenelektrode auf der anderen Oberflächenseite des Plättchens 1 gegenüber.

Diese Elektroden sind vorzugsweise auf der Keramikoberfläche angebrachte Metallisierungsschichten. Sie bestehen z.B. aus Einbrennsilber, wie dies für Elektroden auf Keramik üblich ist.

Mit 5 ist eine auf der Oberfläche des Plättchens 11 angebrachte Zuleitung als Anschluß für die Elektrode 3 bezeichnet. Mit 6 ist die Zuleitung der zur Elektrode 3 gehörenden Gegenelektrode der Rückseite bezeichnet; soweit die Zuleitung 6 auf der Rückseite des Plättchens 1 verläuft, ist sie gestrichelt dargestellt. Mit 7 ist eine an dem Keramikplättchen 1 angebrachte Zuleitung der Elektrode 4 und mit 8 die entsprechende weitere Zuleitung der rückwärtigen, zur Elektrode 4 gehörenden ringförmigen Gegenelektrode bezeichnet. Die Zuleitungen 5 bis 8 bilden Anschlußkontakte, mit denen der mit Elektroden versehene Plättchenkörper 1 als fertiges Bauelement eines erfindungsgemäßen Zündkopplers in die Schaltung mechanisch und elektrisch eingesteckt werden kann. Gestrichelt ist mit 9 auf eine eingangsseitige Steuerelektronik hingewiesen und das mit 10 bezeichnete gestrichelte Kästchen deutet auf die Ausgangsseite mit dem darin enthaltenen Thyristor oder Triac als ein Beispiel für ein zu schaltendes Bauelement.

Die Aufteilung der insgesamt für die Elektroden 3 und 4 zur Verfügung stehenden Scheibenoberfläche auf diese Elektroden 3 und 4 (das gleiche gilt für die auf der Rückseite der Scheibe 11 befindlichen Gegenelektroden) ist so gewählt, daß für die Gesamtfläche der Elektrode 3 und für die Gesamtfläche der Elektrode 4 jeweils integral gleich großer piezoelektrischer Effekt vorliegt, wobei für Resonanzschwingung gilt, daß im zentralen Bereich der Scheibe 11, d.h. im Bereich der Elektrode 3, große mechanische Wechselspannung der Schwingungsbewegung vorliegt, wohingegen im Randbereich der Scheibe 11, d.h. im wesentlichen im Bereich der Elektrode 4, bekanntermaßen weniger große — bis zum Rand der Scheibe auf Null heruntergehende — mechanische Wechselspannung vorliegt. Dies entspricht für die, wie oben bereits erörtert, freischwingenden Scheibe den physikalischen Gesetzen.

In der Fig.2 ist gestrichelt auch eine quadratische Umrandung der Scheibe 11 angedeutet, womit darauf hingewiesen sein soll, daß eine der Fig.1 entsprechende Ausführungsform auch mit einem quadratischen Plättchen statt einer kreisrunden Scheibe, und zwar mit kreisrunder Mittelelektrode, zu realisieren ist. Zweckmäßigerweise füllt dann die Elektrode 4 auch die für das Quadrat hinzukommenden vier Ecken mit aus. Zur Wahrung des piezoelektrischen Gleichgewichts innerhalb der Bereiche der Elektroden 3 und 4 kann der Außendurchmesser der Elektrode 3 und der Innendurchmesser der Elektrode 4 dann entsprechend (geringfügig) größer gewählt werden.

Mit strichpunktierter Linie ist außerdem in Fig.2 noch eine Umrandung des Plättchens 11 in regelmäßiger hexagonaler Form eingezeichnet. Für diese Form gilt insbesondere bezüglich der Elektrodenaufteilung dasjenige, was bereits zu der quadratischen Form gesagt worden ist.

Alle diese im Zusammenhang mit der Fig.2 erörterten Formen des Plättchens bzw. der Scheibe 11 sind durch eine einzige Längenabmessung bereits vollständig beschrieben, so z.B. mit dem Durchmesser $\phi$ für die Kreisscheibe, mit der Kantenlänge a für die quadratische Scheibe und mit der Kantenlänge a' für das hexagonale Plättchen. Die Schwingungsbewegung des Grundmode ist in der Fig.2 durch die eingetragenen Pfeile angedeutet. Diese Schwingungsform gilt prinzipiell unabhängig davon, ob die äußere Umrandung dieses Plättchens 11 ein Kreis, ein Quadrat, ein Sechseck oder ein sonstiges regelmäßiges Vieleck ist.

In der Fig.3 ist für die Plättchenformen der Fig.2 mit den in dieser Fig.3 angegebenen Doppelpfeilen die Schwingungsverteilung des nur in Fig.2 dargestellten ersten Oberwellenmode angedeutet mit der Knotenlinie c. Diese Knotenlinie ist im Falle der Kreisscheibe und im Falle eines vieleckigen Plättchens eine Kreislinie, die im Extremfall des Quadrats dem Quadrat entsprechende geringe Ausbauchungen zu den vier Ecken hin hat.

Fig.4 zeigt ein Plättchen 1 mit quadratischem Querschnitt (wie als alternative Ausführungsform in Fig.2
gestrichelt eingetragen). Die Ausführungsform der
Fig.4 läßt aber die abweichende Elektrodenform erkennen, die z.B. derjenigen entspricht, wie sie bei der
prinzipiellen Darstellung nach Fig.1 gezeigt ist. Mit
13 und 14 sind die beiden streifenförmigen im Abstand
voneinander liegenden (den Elektroden 3 und 4 der Fig.2
entsprechenden) Elektroden der einen Oberfläche bezeichnet. Auf der Rückseite befinden sich die – wie in
Fig.1 ersichtlichen – Gegenelektroden 13' und 14'. Für
flächengleiche Elektroden 13 und 14 ergeben sich ohne
weiteres gleich große piezoelektrische Wirkungen zwischen dem Eingangselektrodenpaar 13, 13' und dem Ausgangselektrodenpaar 14, 14'.

Die mit 5 bis 8 bezeichneten Anschluß-Zuleitungen
wie in Fig.1 entsprechen den Zuleitungen 5 bis 8 der
Fig.2. Vorzugsweise sind diese Zuleitungen am Rande
des Plättchens auf den jeweiligen Elektroden befestigt.

In Fig.5 ist eine Ausführungsform mit kreisrunder Form
des Plättchens 11 gezeigt, auf dem sich halbkreisförmige Elektroden 13 und 14 nebeneinander befinden.

Eine weitere Ausführungsform zeigt Fig.6 mit einer weiteren Art der Aufteilung der Elektroden 13" und 14",
denen jeweils gleich große Gegenelektroden auf der Rückseite des Plättchens direkt gegenüberliegen. Es ist
dies ein Beispiel einer Ausführungsform mit unregelmäßig ineinandergreifenden Elektroden des Eingangs- und
des Ausgangselektrodenpaares.

Es wurde bereits oben erwähnt, daß die Anschluß-Zuleitungen 5 bis 8 vorzugsweise am Rande des Plättchens 1, 11 angebracht werden. Dies steht in scheinbarem Gegensatz zu der Angabe, daß das Plättchen des erfindungsgemäßen Zündkopplers freischwingend gehalten sein soll. Dies läßt sich aber vor allem durch Verwendung von mit Sicken oder dergl. versehenen oder (mit genügend langen Enden) umgebogenen Anschluß-Zuleitungen 5 bis 8 erreichen. Die Fig.7 und 8 zeigen derart ausgestaltete Anschluß-Zuleitungen, und zwar in Seitenansichten bezogen auf die Fig.2 bis 6. Diese Fig.7 und 8 zeigen den plättchenförmigen Körper 1, 11 des Piezo-Zündkopplers, wie er durch die in die Fassung 50 eingesteckten Anschluß-Zuleitungen (nur 5' u. 6' dargestellt) gehaltert wird. Zur Halterung sind nur diese Zuleitungen verwendet.

In den Fig.7 und 8 ist außerdem die beim erfindungsgemäßen Piezo-Zündkoppler vorgesehene Umhüllung 51 aus vorzugsweise Kunstharzlack gezeigt. Diese Umhüllung umschließt das gesamte Plättchen 1, 11, unabhängig von seiner gemäß einem Merkmal der Erfindung vorgesehenen speziellen Formgebung. In diese Umhüllung 51 sind auch die Anschluß-Zuleitungen 5 bis 8 mit eingeschlossen. Insbesondere kann durch diese Umhüllung bereits eine ausreichende mechanische Verbindung der einzelnen Anschluß-Zuleitungen 5 bis 8 mit der jeweiligen Elektrode 3, 3' bzw. 4, 4' erreicht werden, so daß beispielsweise ein Anlöten der Zuleitungen am Material der Elektrode entbehrlich ist.

Von besonderem Vorzug ist es, für die Umhüllung 51 ein als Prepreg bekanntes Glasfaser-Polyestervlies zu verwenden, das nach Auflegen und Anpassen am Plättchen 1, 11 thermisch ausgehärtet wird. Durch das Anpassen der beiden über den Plättchenrand hinausragenden Glasfaser-
Vliesfolien ergibt sich eine dichte randseitige Verbindung der auf die beiden Seiten aufgelegten Vliese miteinander, die auch die durch diese Verbindung herausgeführten Zuleitungen 5 bis 8 besonders gut festhält.

Für das Material der Isolationsumhüllung 51 wird ein
Material eines solchen Elastizitätsmoduls $E_U$ verwendet,
der um ein n-faches (mit n zwischen 5 und 30) kleiner
ist als der Elastizitätsmodul $E_K$ des Plättchens 1, 11.
Damit ist gewährleistet, daß die Schwingfähigkeit des
Plättchens durch die notwendige Isolationsumhüllung 51
nicht beeinträchtigt wird. Hinzu kommt, daß die Isolationsumhüllung auch als mechanisches Stabilisierungsmittel für das notwendigerweise dünne, nur maximal
0,3 mm dicke Plättchen wirksam ist. Es empfiehlt sich,
die Dicke der Umhüllung 51 auf den Oberflächenseiten
des Körpers 1, 11 z.B. für Kunstharzlack 30 bis 100 /um
dick zu machen. Für die Verwendung des oben erwähnten
Glasfaser-Epoxydvlieses empfiehlt sich, eine Dicke des
Vlieses von 50 bis 150 /um zu wählen.

Die Fig.1 zeigt noch ein Schaltungsbeispiel für eine
Ansteuerelektronik 9. Der Steuerimpulseingang ist mit
91 bezeichnet. Das aus Kondensator und Widerstand bestehende RC-Glied 92 dient der Bestimmung der Oszillatorfrequenz, die auf die gewünschte Betriebs-Resonanzfrequenz des vorgesehenen erfindungsgemäßen Piezo-Zündkopplers eingestellt wird. Mit 93 ist ein Schmitt-
Trigger-NAND-Glied bezeichnet. Die Treiberstufen sind
mit 94 bezeichnet und 95 ist der Ausgang der Schaltung
9 mit einem getakteten Wechselstromimpuls, der unter
Einhaltung vorgeschriebener galvanischer Trennung mit
Hilfe des erfindungsgemäß vorgesehenen Piezo-Zündkopplers 1, 11 (Fig.1) an die Zündelektrode des Thyristors oder Triacs 100 derart übertragen wird, daß sicheres und rasches Zünden des Thyristors bzw. Triacs stets gewährleistet ist.

Fig.9 zeigt ein Beispiel zusammen mit einem MOS-Schalter. Mit $\overline{9}$ ist eine Treiberschaltung bezeichnet, die bei Anliegen von H-Potential am Steuereingang $\overline{91}$ der vorgesehenen Ansteuerung des MOS-Leistungsschalters entsprechend getaktetes Signal an das Elektrodenpaar 13, 13' liefert. Dieses Signal ist ein Wechselspannungssignal mit wie vorgegebener, durch die Abmessung des Körpers 1 bestimmter Frequenz zwischen 20 kHz und 500 kHz. Die Frequenz f der Wechselspannung und die zur Anregung vorgesehene Schwingungsresonanz des Körpers 1 sind somit übereinstimmend.

Eine solche Treiberschaltung $\overline{9}$ nach Fig.9 ist als integrierte Schaltung in TTL-Technik mit der Typenbezeichnung 74132 verschiedener Hersteller im Handel. Ihre Bestandteile gehen aus der Darstellung und dem angegebenen Symbol hervor. Diese Treiberschaltung $\overline{9}$ liefert eine Wechselspannung an das Eingangselektrodenpaar 13, 13' des Piezo-Kopplers.

Die Ausgangsseite des Piezo-Kopplers $\overline{1}$, d.h. das Elektrodenpaar 14, 14', ist über die Anschlußleitungen 7 , 8 mit einer Gleichrichterschaltung mit den wie dargestellten Gleichrichtern $\overline{7}$ und $\overline{8}$ verbunden. Ein hochohmiger Ableitwiderstand ist mit $\overline{18}$ bezeichnet. Mit 210 ist der zu schaltende MOS-Leistungsschalter und mit 211 ist der mit dem Schalter 210 in Reihe liegende Lastwiderstand bezeichnet. Wie ersichtlich und wie oben schon angedeutet, liegt der Schalter 210 bei kurzgeschlossenem Schalter, d.h. bei Öffnen der Kanalstrecke des den Schalter 210 bildenden Feldeffekttransistors, mit seinen beiden Anschlüssen Source und Drain auf hohem Potential, d.h. am "heißen" Anschluß des Lastwiderstands 211. Ohne Schwierigkeiten ist eine solche Schaltung bei der Erfindung möglich, weil in der Ausgangsseite des Piezo-Kopplers 7, d.h. im Schaltungsteil bestehend aus dem Elektrodenpaar 14, 14' und den Schaltungselementen 7, 8 und 18, eine solche elektrische Spannung erzeugt wird, die von Bezugspotentialen frei ist und die genügend groß ist, um für das Öffnen des den Schalter 210 bildenden Feldeffekttransistors erforderliche Spannung zwischen Source 212 und 213 zu gewährleisten. Die Anschlußleitung 8 ist dementsprechend mit dem Source-Anschluß 212 des Schalters 210 verbunden. Der Drain-Anschluß 214 des Schalters 210 ist mit positivem Betriebspotential verbunden, wenn der Schalter 210 wie im vorliegenden Falle ein Feldeffekttransistor vom Anreicherungstyp mit N-Kanal ist.

In Fig.9 ist zusätzlich noch gestrichelt eine Strombegrenzungsschaltung, und zwar in zwei Varianten, eingetragen. Mit 101 ist ein elektronisches Bauelement mit den Anschlüssen a, b und c bezeichnet, und ein zusätzlicher Widerstand $R_m$ hat das Bezugszeichen 102. Gemäß einer Alternative kann das Bauelement 101 ein Transistor sein, dessen Anschluß a der Emitter, dessen Anschluß b der Kollektor und dessen Anschluß c die Basis ist. Wenn $R_m$ so bemessen ist, daß $I_{max} \cdot R_m \geqq 0,5$ Volt wird, worin $I_{max}$ der maximal zulässige Strom für den MOS-Leistungsschalter 210 ist, so wird infolge des Umstands, daß der Transistor 101 bei diesen 0,5 Volt leitend wird, der Eingang des Leistungsschalters 210 kurzgeschlossen und der durch den Leistungsschalter 210 fließende Strom in zunehmendem Maße blockiert.

Das Bauelement 101 kann auch ein Thyristor sein, bei dem die Anschlüsse a und b Anode und Kathode sind und c der Anschluß der Zündelektrode ist. Ist $R_m$ so bemessen, daß $I_{max} \cdot R_m \geqq 1$ Volt beträgt, so zündet der Thyristor 101 und schaltet den bisher durch den Leistungsschalter 210 (und den Lastwiderstand $R_L$) fließenden Strom schlagartig ab.

Fig.10 zeigt ein Schaltbild, das die Eingangselektronik 609, den für Betrieb mit Rückkopplung speziell ausgestalteten Piezo-Koppler 601 und den Leistungsschalter 610 mit dem im zu steuernden Stromkreis liegenden Lastwiderstand 611 umfaßt. Die Schaltung der Fig.10 enthält in der Eingangselektronik 609 zwei alternative Ausgestaltungen mit dem Widerstand R oder dem Widerstand $\overline{R}$.

Der Piezo-Koppler 601 hat wie bei vorangegangenen Beispielen einen plättchenförmigen Körper aus piezoelektrischem Material, vorzugsweise Piezokeramik wie Bleizirkonat-Titanat oder dergleichen. Das Eingangselektrodenpaar des Piezo-Kopplers 601 wird wieder durch die Eingangselektrode 13 und ihre Gegenelektrode 13' gebildet. Das Ausgangselektrodenpaar besteht (wieder) aus der Elektrode 14 und der ihr zugehörigen Gegenelektrode 14'. Die Ausgangselektrode 14 ist mit der Steuerelektrode s des elektronischen Schalters 610 verbunden. Ein bestimmungsgemäßes Ausgangssignal, das am Ausgangselektrodenpaar 14, 14' und damit zwischen den Anschlüssen r und t - und zwar unabhängig vom Massepotential - auftritt, schaltet den Schalter 610 und bewirkt Durchgang zwischen den Anschlüssen r und t des Schalters 610, so daß bei anliegender Spannung U der zu schaltende Strom durch den Lastwiderstand 611 fließt.

Wie bereits oben ausführlich beschrieben, bedarf es für die Erzeugung eines Ausgangssignals am Ausgangselektrodenpaar 14, 14' eines angepaßten Eingangssignals am Eingangselektrodenpaar 13, 13' des Piezo-Kopplers 610. Es ist dies auch hier ein Wechselstrom-Eingangssignal mit einer Frequenz f, die gleich der Resonanzfrequenz des Plättchens des Piezo-Kopplers 610 ist, wobei es sich dabei um eine derartige Eigenresonanzfrequenz des Plättchens handelt, die durch die flächenbestimmende Längenabmessung desselben gegeben ist und eine Schwingung nach dem Prinzip der Radialschwingung des Plättchens ist. Der Begriff "Radialschwingung" bedingt damit nicht unbedingt ein kreisrundes Plättchen des Piezo-Kopplers 610, sondern es kann dies wieder auch ein Plättchen in quadratischer Form, regelmäßiger Sechseckform und dergleichen sein, wie dies schon im Hauptpatent ausführlich beschrieben ist.

Das Eingangssignal an dem Eingangselektrodenpaar 13, 13' wird bei der vorliegenden Erfindung von einem Verstärker 681 geliefert, z.B. einem C-MOS-Inverter CD 4011 (der an sich aus vier integrierten Invertern besteht, die vorteilhafterweise einander parallelgeschaltet verwendet werden). Mit 691 ist der Steuereingang der Eingangselektronik 609, d.h. des Inverters 681, bezeichnet, an dem - wie bereits oben erwähnt - der jeweilige Verstärkungsgrad des Inverters 681 zwischen zwei möglichen Zuständen verändert werden kann.

Mit 513 und 513' sind die Elektroden eines Elektrodenpaares bezeichnet, das sich zusätzlich zu den bereits erwähnten Elektroden auf den beiden gegenüberliegenden Oberflächen des Piezo-Kopplers 610 - wie in der Fig.1 angedeutet - befindet. Wie dies im Zusammenhang mit der speziellen Beschreibung von Ausführungsformen des Piezo-Kopplers 610 noch näher erläutert wird, tritt am Rückkopplungs-Elektrodenpaar 613 ein Wechselstromsignal auf, das seinen Ursprung in einer mechanischen Schwingung des piezoelektrischen Plättchens des Piezo-Kopplers 601 hat, wobei diese mechanische Schwingung durch das Anliegen eines Wechselstromsignals am Eingangselektrodenpaar 13, 13' hervorgerufen ist. Wie dies für eine Rückkopplungsschaltung üblich und wohlbekannt ist, entsteht ein solcher rückgekoppelter Schwingungsaufbau dann, wenn in dem gebildeten Rückkopplungskreis eine ausreichende Verstärkung vorliegt, wie sie bei der Eingangselektronik 609 mit dem Verstärker 681 gegeben ist. Die alternativ zu verwendenden Widerstände R und $\bar{R}$ mit der jeweiligen Bemessung $R < \frac{1}{\omega C}$ bzw. $\bar{R} \approx \frac{v}{\omega C_R}$ sorgen dafür, daß in der Rückkopplungsschaltung der Eingangselektronik 609 die für Rückkopplung bei Verwendung des Piezo-Kopplers 601 notwendige jeweilige Phasendrehung vorliegt, und zwar für die Fälle, daß der Verstärkungselement keine Phasendrehung hat oder das Verstärker 681, wie hier der Inverter 681, $\approx 180^o$ Phasendrehung aufweist. In diesen Beziehungen sind die Größe v das Verstärkungsmaß, der Wert C die Kapazität des Eingangselektrodenpaares 13, 13' und der Wert $C_R$ die Kapazität des Rückkopplungs-Elektrodenpaares 613, 613' sowie $\omega$ die Winkelgeschwindigkeit der Resonanzschwingung.

Fig.11 zeigt in den beiden Darstellungen 2a und 2b die beiden Oberflächenseiten ein und desselben Piezo-Kopplers 601. Die beiden Darstellungen sind so zu verstehen, als wäre das Plättchen des Piezo-Kopplers 601 in seiner Mittelebene aufgespalten und als wären die beiden Hälften so aufgeklappt, daß die beiden in der Darstellung der Fig.11 benachbarten Kanten $\alpha$ ein und dieselbe Seitenkante des Plättchens des Piezo-Kopplers 601 sind. Die Fig.2 zeigt also spiegelsymmetrisch die beiden Ansichten der beiden einander gegenüberliegenden Oberflächen des Plättchens.

Mit 13 ist in Fig.11a wieder die eine Elektrode des Eingangselektrodenpaares 13, 13' bezeichnet. Die der Elektrode 13 auf der gegenüberliegenden Seite mindestens gleich große, gegenüberliegende Gegenelektrode 13' ist in der Fig.11.b zu sehen. Die eine Elektrode des Ausgangselektrodenpaares ist in Fig.11a wieder mit 14 bezeichnet. Die ihr gegenüberliegende Gegenelektrode ist in Fig.11b mit 14' bezeichnet. Es sei hier der Hinweis vorweggenommen, daß die Elektroden 13 und 13' bei der hier dargestellten Ausgestaltung nicht deckungsgleich sind.

Die weitere, streifenförmige, auch als Rückkopplungselektrode bezeichnete Elektrode 613 ist in Fig.2a ein Anteil eines Kreisringes mit einem Anschlußstreifen 613*. Mit dem gestrichelt wiedergegebenen Kreisbogen 622 ist auf die Schwingungsknotenlinie der ersten Oberwelle der radialen Schwingung des hier quadratischen Plättchens 601 mit den Seitenlängen a hingewiesen. Wie ersichtlich, erstreckt sich der Streifen der weiteren Elektrode 613 über Flächenanteile des Piezo-Kopplers 601, die im Bereich dieser Schwingungsknotenlinie 622 liegen. Lediglich der Anteil 613* liegt erheblich außerhalb der

0038496

Schwingungsknotenlinie 622. Die weitere Elektrode 613 kann den vollen Kreisring im Bereich entlang der Schwingungsknotenlinie 622 einnehmen. Um jedoch eine Vereinfachung bezüglich einer Verbindung des zentralen Bereiches des Plättchens mit dem übrigen Anteil der Elektrode 13 zu haben, wird bevorzugt - wie dargestellt - nur ein Anteil des vollen möglichen Kreisringes für die weitere Elektrode 613 genutzt.

Wie durch einen Vergleich der beiden Darstellungen 11a und 11b ersichtlich, liegt im Bereich der streifenförmigen, einen Kreisbogenanteil bildenden Elektrode 613 der Vorderseite (Fig.11a) ein Flächenanteil der Gegenelektrode 13' gegenüber. Dies entspricht elektrisch einer galvanischen Verbindung der in Fig.10 angedeuteten Gegenelektroden 13' und 613'. Es ist dies eine Vereinfachung, mit der zuverlässig Deckung zwischen Kreisring der weiteren Elektrode 613 und Gegenelektrode 613' (als Anteil der Elektrode 13') erreicht ist.

Mit 622 ist auch in Fig.11b derselbe Kreis der Schwingungsknotenlinie der ersten Oberwelle angedeutet. Für die Grundschwingung der Radialschwingung des Plättchens des Piezo-Kopplers 601 liegt im Bereich der Kreislinie 622 erhebliche mechanische Wechselspannung der Grundschwingung vor, so daß zwischen der Elektrode 613 und der Gegenelektrode 13' ein erheblich starkes Rückkopplungssignal abgenommen werden kann. Für das Eingangselektrodenpaar ist im übrigen von der Fläche der Elektrode 13' nur derjenige Flächenanteil als Gegenelektrode wirksam, der deckungsgleich mit der Elektrode 13 der Fig.11a ist. Nur dieser Flächenanteil bildet die Kapazität C'.

Die Fig.11 zeigt noch eine weitere Besonderheit gemäß einer erfindungsgemäßen Ausgestaltung, die darin besteht, daß der Anschlußstreifen 613* der weiteren Elektrode 613 keine Gegenelektrode auf der in der Fig.11b wiedergegebenen Rückseite des Piezo-Kopplers 601 hat, d.h. der mit $\overline{613}$ kenntlich gemachte Flächenanteil weist in Fig.11b keine Elektrodenbelegung auf. Somit kann im Bereich des Anschlußstreifens 613* kein Beitrag zum Rückkopplungssignal der weiteren Elektrode 613 auftreten. Der Vorteil dieser Maßnahme liegt darin, daß ansonsten - in dem gedachten Falle - die Schwingung des Piezo-Kopplers 601 springt in den Schwingungsmode der ersten Oberwelle um - noch ein Restsignal an einem Anteil eines Elektrodenpaares 613*, $\overline{613}$ auftreten könnte. Im Falle der Oberschwingung würde nämlich im Bereich des Kreisbogens 613 dieser Rückkopplungselektrode praktisch keinerlei Signal piezoelektrisch erzeugt werden können, nämlich weil dort für diese Oberschwingung ein Schwingungsknoten vorliegt.

Zwischen der weiteren Elektrode 613 mit ihrem Anteil 613* und der Ausgangselektrode 14 auf der einen Seite des Plättchens (Fig.11a) und gegebenenfalls auch zwischen den Gegenelektroden 13' und 14' und der anderen Seite des Plättchens (Fig.11b) ist der jeweils für die galvanische Trennung erforderliche Abstand einzuhalten.

Mit 633 und 633' sind die Anschlußfahnen der Elektroden des Eingangselektrodenpaares 13, 13' bezeichnet. Entsprechende Anschlußfahnen für das Ausgangselektrodenpaar sind mit 634 und 634' bezeichnet. Mit 635 ist auf die Anschlußfahne der weiteren Elektrode 613 hingewiesen, und die bereits erwähnte Anschlußfahne 633' ist bei der hier dargestellten speziellen Ausführungsform der zur Anschlußfahne 635 zugehörige zweite Anschluß.

Die Fig.12 und 13 zeigen eine besondere Ausführungsform eines erfindungsgemäßen Piezo-Kopplers 1', der vergleichsweise zum Ausführungsbeispiel der Fig.4 Rechteckform mit einem zusätzlichen streifenförmigen Ausgangselektrodenpaar 12, 12' mit Anschlußfahnen 17 und 18 an sich hat. Dieser Piezo-Koppler 1' mit seinem doppelten Ausgangselektrodenpaar 12, 12' und 14, 14' ist wie auch aus der Fig.13 ersichtlich besonders geeignet für die Ansteuerung eines Paares 10' antiparalleler Thyristoren 100, 101, wobei diese beiden Thyristoren 100, 101 - wie aus Fig.13 ersichtlich - mit ihren Anschlüssen und insbesondere mit dem Steueranschluß gegeneinander vertauscht mit dem jeweiligen Elektrodenpaar 12, 12' bzw. 14, 14' verbunden sind. Die beiden Thyristoren 100 und 101 bekommen Ausgangssignale des Piezo-Zündkopplers 1' mit zueinander entgegengesetzter Polarität, obwohl nur ein einziger Eingangsimpuls 91' der Ansteuerelektronik 9 an das Eingangselektrodenpaar 13, 13' des Piezo-Zündkopplers geht. Ein solcher spezieller Piezo-Zündkoppler 1' nach Fig.12 und in der Schaltung nach Fig.13 ist besonders dann zu empfehlen, wenn anstelle eines Triacs 10 (schaltungstechnisch vorteilhafterweise) ein wie bereits beschriebenes antiparalleles Thyristorenpaar 100 und 101 bevorzugt wird.

Die von dem Eingangselektrodenpaar 13, 13' ausgehende elektrisch erzeugte akustische Welle im Körper des Piezo-Kopplers 1' wird sowohl zwischen den Elektroden 12, 12' als auch zwischen den Elektroden 14, 14' wirksam. Dies gilt generell auch für eine wie oben beschriebene Resonanzanregung des Piezo-Zündkopplers 1', wobei lediglich darauf zu achten ist, daß keines der Elektrodenpaare sich überwiegend bzw. im wesentlichen ausschließlich über Bereiche einer Schwingungsknotenlinie des Körpers des Piezo-Zündkopplers 1' erstreckt. Die galvanische Entkopplung ist wiederum durch den Abstand zwischen Eingangselektrodenpaar 13, 13' und dem nächstliegenden Ausgangselektrodenpaar 12, 12' gewährleistet. Beide Thyristoren 100 und 101 werden durch den Eingangsimpuls 91 gleichzeitig gezündet.

Wie oben bereits mehrfach erwähnt und wie auch aus den Figuren ersichtlich, ist die von den Elektroden 4, 4'; 14, 14' des Ausgangselektrodenpaares bedeckte Fläche des Plättchens 1, 1', 11, 601 gleich groß oder wenigstens weitgehend gleich groß bzw. in der Größenordnung wie die von den Elektroden 3, 3'; 13, 13' des Eingangselektrodenpaares bedeckte Fläche desselben Plättchens, so daß ein Übersetzungsverhältnis vom Eingang zum Ausgang von im wesentlichen bzw. in der Größenordnung 1:1 vorliegt. Bezüglich der Elektrodenfläche ist zu berücksichtigen, daß entsprechend dem jeweiligen Schwingungsmode des Plättchens einzelne Flächenelemente desselben unterschiedlich groß wirksamen Beitrag zur piezoelektrischen Signalübersetzung vom Eingang zum Ausgang bringen.

Patentansprüche:

1. Piezo-Zündeinrichtung für elektronische Schalter mit galvanischer Entkopplung von Eingangssteuerelektronik und elektronischem Schalter, g e k e n n z e i c h n e t durch eine Vorrichtung mit einem Plättchen (1, 1', 11,601) aus piezokeramischem Material, auf dessen einer Oberfläche wenigstens zwei Elektroden (3, 4; 13, 12, 14) und auf dessen gegenüberliegender Oberfläche die zugehörigen Gegenelektroden (3', 4'; 13', 12', 14') angeordnet sind, wobei Elektrode (3, 4, 12, 13, 14) und Gegenelektrode (3', 4', 12', 13', 14') eines Elektrodenpaares sich jeweils im wesentlichen deckungsgleich gegenüberliegen, wobei wenigstens zwei Elektroden (3, 4; 13, 12 bzw. 14) der einen Oberfläche des Plättchens (1, 1', 11) einen für die galvanische Entkopplung ausreichenden elektrischen Isolationsabstand voneinander haben, und dadurch, daß ein Elektrodenpaar (3, 3', 13, 13') als Eingangselektrodenpaar mit der Steuerelektronik (9, 9') verbunden ist und daß das eine oder die mehreren weiteren Elektrodenpaare (4, 4'; 12, 12', 14, 14') als jeweiliges Ausgangselektrodenpaar mit der (jeweiligen) Zündelektrode des elektronischen Schalters verbunden ist (sind).

2. Piezo-Zündeinrichtung nach Anspruch 1, g e k e n n z e i c h n e t dadurch, daß die Elektroden (3, 4) der jeweiligen Oberflächen kreissymmetrisch zueinander angeordnet sind.

3. Piezo-Zündeinrichtung nach Anspruch 1 oder 2, g e - k e n n z e i c h n e t dadurch, daß die Elektroden (12, 13, 14) als Streifen auf der Oberfläche des Plättchens (1') angeordnet sind.

4. Piezo-Zündeinrichtung nach Anspruch 1, 2 oder 3, g e k e n n z e i c h n e t dadurch, daß ein Eingangs-

elektrodenpaar (13, 13') und zwei Ausgangselektrodenpaare (12, 12', 14, 14') vorgesehen sind, von denen die
Ausgangselektrodenpaare mit der jeweiligen Zündelektrode je eines Thyristors (101, 100) verbunden sind,
die in antiparalleler Schaltung geschaltet sind (Fig.12,
Fig.13).

5. Piezo-Zündeinrichtung nach Anspruch 1, 2, 3 oder 4,
g e k e n n z e i c h n e t durch ein weniger als
0,3 mm dickes Plättchen als Piezo-Zündkoppler, auf dessen einer Oberfläche die wenigstens zwei Elektroden (13,
14) und auf dessen gegenüberliegender Oberfläche die
wenigstens zwei jeweils gleich großen Gegenelektroden
(13', 14') angeordnet sind, wobei das Plättchen (1, 1',
11) eine Form mit einer mehr als zweizähligen Drehsymmetrieachse hat, und dadurch, daß von der Steuerelektronik (9; $\overline{9}$) an das Eingangselektrodenpaar (13, 13')
ein Wechselstromsignal gegeben wird, dessen Frequenz f
und eine durch die flächenbestimmende Längenabmessung( $\emptyset$,
a, a') gegebene Resonanzfrequenz des Plättchens (1, 1',
11) auf einen Wert zwischen 20 kHz und 500 kHz für einen
Schwingungsmode nach dem Prinzip der Radialschwingung
aufeinander abgestimmt sind.

6. Piezo-Zündkoppler für eine Zündeinrichtung nach
Anspruch 5, g e k e n n z e i c h n e t dadurch, daß
eine an der Oberfläche des Plättchens (1, 1', 11) bzw.
an dessen Elektroden (3, 4; 13, 14) dicht anliegende
Umhüllung (51) vorgesehen ist, die auch die Anschlüsse
der Anschluß-Zuleitungen (5, 6, 7, 8) an den Elektroden
(3, 4; 13, 14) mit abdeckt, wobei diese Umhüllung (51)
eine Dicke hat, die gleich groß oder größer als die
Dicke des Plättchens (1, 1', 11) ist und die Umhüllung
(51) aus einem elektrisch nichtleitenden Material mit
einem Elastizitätsmodul $E_M$ besteht, und $E_M \leq 0,2 \cdot E_K$ ist,

worin $E_K$ der Elastizitätsmodul des piezokeramischen Materials des Plättchens (1, 1', 11) ist, wobei dieses Material eine Schwinggüte Q (reziproke mechanische Dämpfung) von mehr als Q = 10 besitzt.

7. Piezo-Zündkoppler nach Anspruch 6, g e k e n n - z e i c h n e t dadurch, daß die Umhüllung (51) aus einem Kunstharzlack besteht.

8. Piezo-Zündkoppler nach Anspruch 6, g e k e n n - z e i c h n e t dadurch, daß die Umhüllung (51) aus durch Wirbelsintern aufgebrachtes Kunststoffmaterial besteht.

9. Piezo-Zündkoppler nach Anspruch 6, g e k e n n - z e i c h n e t dadurch, daß die Umhüllung (51) ein Epoxyd-Glasfaservlies (Prepreg) ist.

10. Piezo-Zündkoppler für eine Zündeinrichtung nach einem der Ansprüche 1 bis 4 oder nach Anspruch 6, g e - k e n n z e i c h n e t dadurch, daß die Anschluß-Zuleitungen (5 bis 8) der Elektroden (3, 4; 13, 14) als einzige vorhandene mechanische Halterungen des Plättchens (1, 1', 11) ausgebildet sind.

11. Piezo-Zündkoppler nach einem der Ansprüche 6 bis 10, g e k e n n z e i c h n e t dadurch, daß das Plättchen (11) kreisrunde Form hat.

12. Piezo-Zündkoppler für eine Zündeinrichtung nach Anspruch 1 oder nach einem der Ansprüche 6 bis 10, g e - k e n n z e i c h n e t dadurch, daß das Plättchen (1) quadratische Form hat.

13. Piezo-Zündkoppler für eine Zündeinrichtung nach Anspruch 1 oder nach einem der Ansprüche 6 bis 12, g e k e n n z e i c h n e t dadurch, daß die Flächen der Elektroden (3, 4) auf den beiden Plattenoberflächen konzentrisch zueinander angeordnet sind (Fig.2).

14. Piezo-Zündkoppler für eine Zündeinrichtung nach Anspruch 1 oder nach einem der Ansprüche 6 bis 12, g e k e n n z e i c h n e t dadurch, daß die Flächen der Elektroden (3', 4', 13, 14) auf den beiden Plattenoberflächen parallel (spiegelsymmetrisch) zueinander angeordnet sind (Fig.4 und 5).

15. Piezo-Zündkoppler für eine Zündeinrichtung nach Anspruch 1 oder nach einem der Ansprüche 6 bis 12, g e k e n n z e i c h n e t dadurch, daß die Flächen der Elektroden (13", 14") auf den beiden Plattenoberflächen unsymmetrisch ineinandergreifend angeordnet sind (Fig.6).

16. Piezo-Zündkoppler nach einem der Ansprüche 10 bis 15, g e k e n n z e i c h n e t dadurch, daß die auch als mechanische Halterungen ausgebildeten Anschluß-Zuleitungen (5 bis 8) im Bereich eines der Ränder des Plättchens (1, 1', 11) auf dessen Plattenoberflächen befestigt sind.

17. Piezo-Zündkoppler nach einem der Ansprüche 10 bis 16, g e k e n n z e i c h n e t dadurch, daß die Anschluß-Zuleitungen mit wenigstens einer Biegung versehen sind (Fig.7 und 8).

18. Piezo-Zündkoppler nach einem der Ansprüche 5 bis 17, g e k e n n z e i c h n e t dadurch, daß auf der einen Oberfläche des Plättchens des Piezo-Kopplers (601) noch eine weitere, im wesentlichen streifenförmige Elektrode (613) mit einer Gegenelektrode (613') auf der gegenüberliegenden Oberfläche des Plättchens vorgesehen ist; daß sich diese weitere Elektrode (613) weitgehend in einem Bereich des Plättchens befindet, in dem die Schwingungsknotenlinie (622) der mechanischen Spannung des zum bestimmungsgemäßen Schwingungsmoduls nächsthöheren Radialschwingungsmode, vorliegt; daß das an das Eingangselektrodenpaar (13, 13') gelangende Wechselstromsignal ein solches Signal ist, das vom Signal dieser weiteren Elektrode (613) und ihrer Gegenelektrode (613') abgeleitet ist; und daß die Eingangselektronik (609) einen Verstärker (681) mit einer Spannungsverstärkung $>1$ und mit einer Stromverstärkung $>n$ enthält, wobei n das Verhältnis zwischen dem Maß der Oberfläche des wirksamen Anteils des Eingangselektrodenpaares (13, 13') und dem Maß der wirksamen Elektrodenfläche (613) der weiteren Elektrode ist, und wobei die Verstärkung (v) an einem Eingang (691) des Verstärkers (681) steuerbar ist und die Eingangselektronik (609) insgesamt eine Phasendrehung von 90° zwischen dem Signal am Eingangselektrodenpaar (13, 13') und dem an der weiteren Elektrode (613) hat.

19. Piezo-Zündkoppler nach Anspruch 18, g e k e n n - z e i c h n e t dadurch, daß die Gegenelektrode (613') der weiteren Elektrode ein zusätzlicher, integraler Anteil der Gegenelektrode (13) des Eingangselektrodenpaares (13, 13') ist.

20. Piezo-Zündkoppler nach Anspruch 18 oder 19, g e - k e n n z e i c h n e t dadurch, daß zu demjenigen Anteil der weiteren Elektrode (613), der im wesentlichen außerhalb des Bereichs der Schwingungsknotenlinie (622) der Oberwelle liegt, die Gegenelektrode (613') auf der gegenüberliegenden Oberfläche des Plättchens
wenigstens weitgehend weggelassen ist.

21. Piezo-Zündkoppler nach Anspruch 18, 19 oder 20,
g e k e n n z e i c h n e t  dadurch, daß diese weitere
Elektrode (613) auf der Oberfläche des Plättchens in
einem Bereich vorgesehen ist, der zwischen den auf dieser Oberfläche befindlichen Elektroden (13, 14) von Eingangselektrodenpaar und Ausgangselektrodenpaar liegt,
wobei diese weitere Elektrode (613) den erforderlichen
Isolationsabstand zur auf dieser Oberfläche benachbarten
Elektrode (14) des Ausgangselektrodenpaares (14, 14')
hat.

22. Piezo-Zündkoppler nach einem der Ansprüche 18 bis 21,
g e k e n n z e i c h n e t  dadurch, daß die weitere
Elektrode (613) die Form wenigstens eines Anteils eines,
bezogen auf das Plättchen, axialen Kreisringes hat, dessen mittlerer Durchmesser etwa $\frac{1}{2}$ mal so groß wie die frequenzbestimmende Abmessung (a) des Plättchens ist.

23. Piezo-Ansteuerungseinrichtung mit Piezo-Zündkoppler
nach einem der Ansprüche 18 bis 22, g e k e n n z e i ch-
n e t  dadurch, daß die zusätzliche Phasendrehung durch
einen vorhandenen Widerstand erzeugt ist, dessen Widerstandswert R kleiner $\frac{1}{\omega C}$ ist, der mit seinem einen Anschluß mit der weiteren Elektrode (613) und mit seinem
anderen Anschluß mit der dieser weiteren Elektrode (613)
zugehörigen Gegenelektrode (613') verbunden ist, wobei
der Verstärker keine Phasendrehung hat.

24. Piezo-Ansteuerungseinrichtung mit einem Zündkoppler
nach einem der Ansprüche 20 bis 22, g e k e n n z e i ch-
n e t  dadurch, daß für die zusätzliche Phasendrehung
der Verstärker eine Phasendrehung von 180° hat und ein Widerstand mit einem Widerstandswert von $\bar{R} \approx \frac{v}{\omega C_R}$ ist, und dessen einer Anschluß mit dem Ausgang des Verstärkers und dessen anderer Anschluß mit der weiteren Elektrode verbunden ist, wobei v die Spannungsverstärkung des mit dem Piezo-Koppler belasteten Verstärkers ist.

25. Piezo-Ansteuerungseinrichtung nach Anspruch 24, g e k e n n z e i c h n e t dadurch, daß der Verstärker wenigstens ein C-MOS-Gatter ist.

26. Piezo-Zündeinrichtung nach Anspruch 1 mit einem Piezo-Zündkoppler nach einem der Ansprüche 6 bis 25, g e k e n n z e i c h n e t dadurch, daß zusätzlich eine Strombegrenzung vorgesehen ist, mit der der Eingang eines MOS-Leistungsschalters kurzgeschlossen wird, wobei diese Schaltung einen Transistor oder Thyristor (101) und einen Widerstand ($R_m$) hat, der in den vom MOS-Leistungsschalter zu schaltenden Stromkreis eingefügt ist, und wobei der Spannungsabfall an diesem Widerstand ($R_m$) den Transistor bzw. Thyristor (101) steuert.

FIG 1

FIG 2

FIG 3

FIG 4

## FIG 5

3  11  4

5  6  7  8

## FIG 6

1

14''

7  5  13''  6  8

## FIG 7

51

1

13  13'

5'  6'

50

## FIG 8

51  1  13'

13

5'  6'

50

FIG 9

FIG 10

FIG 11

FIG 12

FIG 13

**Europäisches Patentamt**

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | US - A - 1 931 028 (W.A. MARRISON)<br>* Seite 1, Zeilen 61 bis 76<br>und Zeilen 92 bis 105;<br>Fig. 1, Positionen 1 bis 8;<br>Fig. 4 *<br>— | 1,3 |
| A | DE - B - 1 616 505 (CLEVITE CORP.) .<br>* Patentanspruch 1; Spalte 4,<br>Zeilen 21 bis 48; Spalte 6,<br>Zeilen 8 bis 32;<br>Fig. 1, 2 *<br>— | 5<br><br><br>2,11,13 |
| A | DE - A1 - 2 532 227 (THOMSON-CSF)<br>* Fig. *<br>— | 3 |
| A | DE - B - 1 591 298 (MURATA MANUFACTURING<br>CO. LTD.)<br>* Spalte 4, Zeilen 45 und 46;<br>Fig. 7, Position 12 *<br>— | <br><br>7<br>6 |
| A | DE - B2 - 2 426 407 (TOKYO SHIBAURA<br>ELECTRIC CO., LTD.)<br>— | |
| A | US - A - 3 872 326 (S. KRISHNA et al.)<br>— | |

**KLASSIFIKATION DER ANMELDUNG (Int. Cl.³)**

H 02 M 1/08
H 03 K 5/00
H 03 H 9/15

**RECHERCHIERTE SACHGEBIETE (Int. Cl.³)**

H 01 H 57/00
H 01 L 27/20
H 01 L 41/00
H 02 M 1/08
H 03 H 9/15
H 03 K 5/00
H 03 K 17/00

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde
liegende Theorien oder
Grundsätze
E: kollidierende Anmeldung
D: in der Anmeldung angeführtes
Dokument
L: aus andern Gründen
angeführtes Dokument
&: Mitglied der gleichen Patentfamilie, übereinstimmendes
Dokument

Der vorliegende Recherchenbericht wurde für alle Patentansprüche erstellt.

| Recherchenort | Abschlußdatum der Recherche | Prüfer |
|---|---|---|
| Berlin | 15-07-1981 | ARENDT |

EPA form 1503.1 08.78